# EUROPEAN PATENT SPECIFICATION

(11) **EP 3 093 105 B1**
(45) Date of publication and mention of the grant of the patent: **24.06.2020**
(21) Application number: 16169066.4
(22) Date of filing: 10.05.2016
(51) Int. Cl.: B24B 37/10, B24B 37/04, B24B 37/08, B24B 7/22, B24B 7/24

(54) **METHOD FOR PRODUCING SUBSTRATES**
VERFAHREN ZUR HERSTELLUNG VON SUBSTRATEN
PROCÉDÉ DE PRODUCTION D'UN SUBSTRAT

(30) Priority: 13.05.2015 JP 2015098267; 05.06.2015 JP 2015114759
(43) Date of publication of application: 16.11.2016
(73) Proprietor: Shin-Etsu Chemical Co., Ltd., Tokyo (JP)
(72) Inventor: MATSUI, Harunobu, Niigata-ken (JP); HARADA, Daijitsu, Niigata-ken (JP); TAKEUCHI, Masaki, Niigata-ken (JP)
(74) Representative: Mewburn Ellis LLP

(56) References cited:
- EP-A1- 2 189 240
- US-A- 5 967 882
- US-A1- 2005 064 796
- US-A1- 2010 009 155
- US-A1- 2011 204 024
- US-A1- 2012 315 739

## Description

### TECHNICAL FIELD

The present invention relates to a method for producing polished substrates, especially of synthetic quartz glass, such as are employed in high-tech industry covering especially photomasks, optical sensors, sequencer chips, etc.

### BACKGROUND

Precision instruments are incorporated with such devices as semiconductor integrated circuits which are produced by the process involving optical lithography or nano-imprinting. This process is strongly required to yield a substrate free of defects as much as possible on its surface. Any defect on a masking substrate, for example, to be used as an original plate for exposure in photolithography, would be transferred to cause defective patterning.

The above-mentioned substrate varies in thickness depending on its uses. Usually, it may be as thin as about 0.1 to 1.0 mm if it is intended for complementary metal-oxide semiconductor (CMOS) sensors, light waveguide sensors, sequencer chips, etc. Such thin substrates, glasses used in DNA sequencer chips for example, are conventionally produced by forming a pattern on one side of a thick substrate and grinding the reverse side subsequently. This conventional process consisting of patterning and ensuing grinding has a disadvantage that the substrate is liable to break as the patterning becomes more intricate than before with generation change. One way under development to overcome this disadvantage is by patterning on an originally thin substrate.

Production of those substrates for photomasks and optical sensors usually involves several steps, such as lapping and polishing, to prepare the surface with a high degree of flatness and a minimum of defects.

A substrate of synthetic quartz glass suffers impact during lapping and polishing, with the magnitude of impact varying between them. Lapping gives rise to a much more significant impact than polishing, because lapping usually employs a lapping plate of cast iron, which is much harder than the substrate, and the lapping plate comes into direct contact with the substrate. By contrast, polishing only causes insignificant impact, because polishing employs a polishing cloth, which is softer than the substrate.

In order to minimize defects caused by impact on the substrate surface, there have been proposed several methods for applying the lapping plate onto the substrate in the lapping step.

An example of such methods, disclosed in JP-A 2012-192486, consists of pressing the polishing plate against the substrate by means of hydraulic pressure instead of conventional pneumatic pressure. The hydraulic pressure is exempted from the irregular pressure fluctuation characteristic of air stream, and hence it does not apply any uneven pressure to the substrate when the polishing plate comes into contact with the substrate and while polishing is performed. Thus, the disclosed method permits any thin workpiece to be fabricated without damage.

Another example of methods, disclosed in JP-A H09-109021, consists of employing a suction pad that levels warpage on the substrate surface to be polished, and also employing a highly rigid polishing plate with minimum warpage, thereby keeping uniform the pressure applied to the surface being polished, Thus, the disclosed method is able to prevent uneven pressure from occurring in the substrate surface when the polishing plate comes into contact with the substrate and while polishing is performed.

US2012/315739A and US2010/009155A show polishing processes in which substrate stocks (semiconductor wafers) are placed in individual work holes formed in a carrier plate provided between upper and lower grinding platens.

### Citation List

Patent Document 1: JP-A 2012-192486
Patent Document 2: JP-A H09-109021

### THE INVENTION

However, the method disclosed in JP-A 2012-192486 seems to be unsuccessful in completely avoiding irregular pressure fluctuation when the polishing plate comes into contact with the substrate surface and while polishing is performed, because it is designed to control pressure by means of liquid like water current.

Moreover, the method disclosed in JP-A H09-109021 is likely to cause cracking to the substrate (especially a thin one) at the time of warpage correction because it uses suction to correct the substrate shape. In addition, it is practically unable to completely eliminate non-uniformity in the surface under the polishing pressure and hence is liable to cause fatal (killer) defects to the substrate surface even though it employs a nearly undeformable polishing plate. It has another disadvantage that any precision polishing plate will cost much and need a long time to prepare.

It is an object of the present invention to provide a new and useful method for producing polished substrates, particularly those of synthetic quartz glass, while saving the substrate surface from killer defects, without needing to resort to large-scale apparatus and specially-adapted precision polishing plates, thereby reducing defectives and improving yields more than in production with conventional facilities.

In order to tackle the above-mentioned problems, the present inventors conducted investigations while focusing on the landing of the polishing plate at the time of substrate fabrication. As a result, it was found that improvements can be achieved if the upper polishing plate is brought into contact with the substrate surface while the lower polishing plate (which supports the substrate coated with a liquid to absorb impact) is being rotated. This method helps produce substrates of any size (particularly thin ones) free of the surface defects which are liable to occur at the time of contact between the polishing plate and the substrate surface.

Thus, the present invention provides a method for producing polished substrates as defined in claim 1, comprising the steps of:
placing substrate stocks on a lower polishing plate in individual work holes formed in a carrier,
bringing an upper polishing plate into contact with the surfaces of said substrate stocks, and
rotating said upper and lower polishing plates, with supply of a polishing slurry to the surfaces of said substrate stocks to polish the substrate stocks;
characterized in that
an impact-absorbing liquid is applied onto the surfaces of said substrate stocks, and said bringing of the upper polishing plate into contact with said surfaces is while they are coated with the impact-absorbing liquid and while the lower polishing plate is being rotated.

When the upper polishing plate is brought into contact with the surface of the substrate stocks, the lower polishing plate may be rotating at 1 rpm to 4 rpm.

The impact-absorbing liquid may be an aqueous solution containing at least one species selected from glycols, polyacrylic acid and derivatives thereof, poly(meth)acrylic acid and derivatives thereof, diethanolamine, and triethanolamine.

The impact-absorbing liquid may have a viscosity of 10 mPa·s to 100 mPa·s at 20°C.

The upper polishing plate may be lowered at a rate of 5 mm/second to 20 mm/second until it comes into contact with the surface of the substrate stocks.

The polishing slurry may be an aqueous dispersion containing at least one species of abrasive grains selected from alumina abrasive grains, silicon carbide abrasive grains, and zirconium oxide abrasive grains.

The substrate stocks may have a thickness of 0.1 mm to 7 mm before polishing.

The substrate stocks may be synthetic quartz glass.

The polishing step may correspond to a lapping step.

### ADVANTAGEOUS EFFECTS

The present invention offers an advantage over the conventional processing method in that it reduces the possibility of damage (such as cracking) occurring on the surface of substrate stocks when the upper polishing plate comes into contact with the surface of the substrate stocks. Moreover, the method of the present invention does not need any additional steps for protecting the surface of substrate stocks from cracking when the upper polishing plate comes into contact with the surface of substrate stocks. Consequently, the present invention not only improves yields and productivity but also effectively utilizes the existing facilities without a large amount of investment.

### BRIEF DESCRIPTION OF THE DRAWING

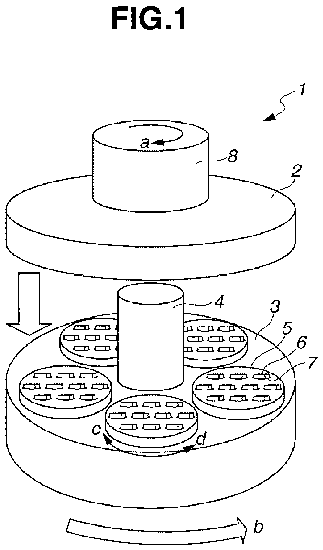

FIG. 1 is a schematic diagram showing one example of a double-sided polishing apparatus used in examples of the present invention.

### FURTHER EXPLANATIONS; OPTIONS AND PREFERENCES

The present invention will be described below with reference to the accompanying drawing.

The method herein for producing substrates by polishing includes steps of placing substrate stocks individually in work holes formed in a carrier on a lower polishing plate, bringing an upper polishing plate into contact with the surface of the substrate stocks, with the surface of the substrate stocks (in the work holes) being coated with an impact-absorbing liquid and the lower polishing plate being rotated, so that the upper polishing plate gently comes into contact with the surface of substrate stocks, with the amount of touching force reduced.

The method for producing substrates may be applied by employing a double-sided polishing apparatus shown in FIG. 1. The polishing apparatus 1 includes an upper polishing plate 2 capable of vertical movement, a lower polishing plate 3 facing the upper polishing plate 2, and a plurality of carriers 5 arranged at equal intervals around a rotating shaft 4 of the lower polishing plate 3. Each carrier has a plurality of work holes 7 which hold substrate stocks (works/workpieces) 6. Each work hole holds one substrate stock. The carrier is thinner than the substrate stocks, so that the substrate stocks 6 are polished as the upper polishing plate 2 moves downward to hold the substrate stocks between the upper polishing plate 2 and the lower polishing plate 3 and the upper polishing plate 2 is rotated in the direction of arrow "a" (at a prescribed speed) around a rotating shaft 8 thereof and the lower polishing plate 3 is rotated in the direction of arrow "b" around the rotating shaft 4 of the lower polishing plate 3 and each carrier 5 is rotated in the direction of arrow "c" or arrow "d", with polishing slurry (not shown) being supplied to the interface between the upper polishing plate 2 and the substrate stocks 6.

If the upper polishing plate is brought downward vertically into contact with the substrate stocks held in the work holes in the carrier on the lower polishing plate which remains stationary, then the substrate stocks receive a force having only one vertical component. This force, if excessively large, will damage the surface of the substrate stocks when the upper polishing plate comes into contact with the surface of the substrate stocks.

However, in the case where the lower polishing plate is rotating when the upper polishing plate comes into contact with the surface of the substrate stocks held in the work holes on the lower polishing plate, the surface of the substrate stocks receives a resultant force composed of a vertical component (due to downward motion of the upper polishing plate) and a horizontal component (due to the rotation of the lower polishing plate). In other words, the resultant vector applied to the substrate stocks at the time of contact with the upper polishing plate is inclined toward the horizontal direction from the vertical direction with respect to the substrate stocks. Thus, it is possible to reduce the vertical force largely responsible for serious damage to the substrate stocks.

Moreover, application in advance of a liquid onto the surface of the substrate stocks to absorb impact further protects the substrate stocks from impact in the vertical direction that occurs when the upper polishing plate comes into contact with the surface of substrate stocks. This step may be accomplished by placing the substrate stocks in a vessel holding an impact-absorbing liquid or by spraying the substrate stocks (held in the working carrier) with an impact-absorbing liquid.

The thus applied impact-absorbing liquid reduces various defects which would otherwise occur on the surface of substrate stocks. Such defects include crow's tracks, macroscratches, etc. as defined in Japanese Industrial Standards (JIS) H 0614.

The impact-absorbing liquid becomes irregular in coating thickness due to surface tension as time passes after its application onto the surface of the substrate stocks. However, the coating thickness remains uniform if the lower polishing plate is rotated so that a force in the horizontal direction is applied to the liquid coating on the surface of substrate stocks. Also, the rotation of the lower polishing plate protects the substrate stocks from irregular pressure which is applied by the upper polishing plate when the upper polishing plate comes into contact with the substrate stocks.

The impact-absorbing liquid should preferably be an aqueous liquid containing at least one species selected from glycols such as ethylene glycol, propylene glycol, polyethylene glycol, and polypropylene glycol; polyacrylic acid and derivatives thereof such as polyacrylic acid and sodium polyacrylate: poly(meth)acrylic acid and derivatives thereof such as poly(meth)acrylic acid and sodium poly(meth)acrylate; diethanolamine, and triethanolamine.

The impact-absorbing liquid should preferably have a viscosity of 10 mPa·s or more, such as 10 mPa·s to 100 mPa·s, preferably 10 mPa·s to 70 mPa·s, more preferably 20 mPa·s to 50 mPa·s, at 20°C. This requirement is set so that the impact-absorbing liquid freely flows and evenly spreads over the surface of substrate stocks, thereby effectively avoiding irregular pressure applied by the upper polishing plate. In the present disclosure, the above-mentioned viscosity is as measured using a rotary viscometer such as Model TVC-7, made by Toki Sangyo Co., Ltd.

While the upper polishing plate is coming into contact with the surface of substrate stocks, the lower polishing plate should rotate desirably at from 1 rpm to 4 rpm, preferably 2 rpm to 4 rpm, so that damage to the substrate stocks is minimal. The direction of rotation is not specifically restricted. It is desirable that the upper and lower polishing plates should turn oppositely to each other, so that the upper polishing plate rotates at a high horizontal speed relative to the surface of the substrate stocks and the surface of the substrate stocks receives a force in the direction inclined toward the horizontal due to the combination of the vertical force applied by the upper polishing plate and the horizontal force applied by the rotating substrate stocks.

The upper polishing plate should preferably be lowered at a speed of not more than 20 mm/second, such as from 5 mm/second to 20 mm/second, preferably 5 mm/second to 15 mm/second, more preferably 5 mm/second to 10 mm/second, in consideration of avoiding damage to the substrate stocks while also avoiding possible evaporation of the impact-absorbing liquid.

After the upper polishing plate has come into contact with the surface of substrate stocks, polishing may be accomplished under ordinary conditions for the rotational speed and polishing pressure of the upper and lower polishing plates.

The polishing slurry to be applied to the surface of substrate stocks at the time of polishing should contain abrasive grains, desirably selected from those of alumina, silicon carbide, and zirconium oxide. Such abrasive grains preferably have a primary particle diameter in the range of 0.5 µm to 50 µm, preferably 0.5 µm to 30 µm, more preferably 0.5 µm to 10 µm. This requirement is set in consideration of the vulnerability of the substrate surface to damage caused by polishing. Incidentally, the particle diameter of the abrasive grains may be determined by using the zeta potential and particle diameter measuring system as is known, e.g. ELSZ-1000ZS, made by Otsuka Electronics Co., Ltd.

The abrasive grains may be commercial ones or may be used in the form of an aqueous dispersion (in pure water) of solid abrasive grains. An example of alumina abrasive grain is that of FO series available from Fujimi Incorporated. An example of silicon carbide abrasive grain is that of GP series and GC series available from Shinano Electric Refining Co., Ltd. and Fujimi Incorporated, respectively. An example of zirconium oxide abrasive grain is that of MZ series, DK-3CH series, and FSD series available from Daiichi Kigenso Kagaku Kogyo Co., Ltd.

The method of the present invention should preferably be applied to production of substrates from synthetic quartz glass. Such substrates may be obtained through the steps of making a synthetic quartz glass ingot, annealing, slicing, edging, lapping, and polishing on both sides for mirror finish. The method of the present invention may also be applied to production of substrates of soda lime glass, silicon wafer, sapphire, gallium nitride, lithium tantalite, etc. by the same steps as mentioned above.

The method of the present invention may be applied to any substrate without specific restrictions on its size and thickness. It produces its maximum effect when applied to thin substrates with a thickness ranging from 0.1 mm to 7 mm, preferably 0.1 mm to 1 mm. Although thin substrates are usually vulnerable to damages to their surface during processing, especially due to impacts that occur when the upper polishing plate comes into contact with substrates, it is possible to avoid such damages, thereby remarkably reducing the level of defectiveness, with the methods described herein.

The substrate to be fabricated by the method of the present invention may be square or circular in shape. Square substrates measure 6-inch (152.4 mm) square and 6.35 mm in thickness (corresponding to 6025 substrate), 6-inch square and 2.3 mm in thickness (corresponding to 6009 substrate), 6-inch square and 0.35 mm in thickness, or 400-mm square and 1.0 mm in thickness. Circular substrates (in the form of wafers) measure 6 inches (152.4 mm), 8 inches (203 mm), and 12 inches (305 mm) in diameter, with a thickness ranging from 0.1 mm to 0.5 mm. These substrate stocks are suitable for polishing by the method of the present invention.

The method of the present invention may be applied usually to the batch-wise polishing of both sides. However, it may also be applied to the polishing of single sides in the sheet-fed mode. Either way of polishing includes the step of bringing the polishing plate into contact with the substrate stocks.

### EXAMPLES

The present invention will be described below to demonstrate its effect with reference to Working Examples and Comparative Examples.

### Working Examples 1 to 6

Polishing was performed as follows on the substrate stocks of synthetic quartz glass (8 inches (203 mm) in diameter and 0.3 mm in thickness) which are held in the work holes as shown in FIG. 1. The upper polishing plate was brought into contact with the substrate stocks, while the lower polishing plate was rotating, under the conditions shown in Table 1. The substrate stocks had their surface coated with an impact-absorbing liquid, which is an aqueous solution of ethylene glycol having a viscosity of 18 mPa·s at 20°C. The upper polishing plate in contact with the surface of the substrate stocks was rotated, with the interface between the substrate surface and the upper polishing plate being supplied with a slurry composed of pure water and silicon carbide abrasive grains called "Shinanorundum GP #4000," made by Shinano Electric Refining Co., Ltd. In each example, a hundred pieces of substrate stock underwent polishing. After polishing, the specimens were examined for flaws to count the percent defective. Any specimen was regarded as defective if it had on its surface one or more flaws (such as crow's track and macroscratch) defined in JIS H 0614.

Incidentally, polishing was performed by using a polishing machine, "16BF for two-side polishing" available from Hamai Co., Ltd.

**Table 1**

| Working Example No. | Descending speed of upper polishing plate (mm/second) | Rotating speed of lower polishing plate (rpm) | Percent defective after polishing (%) |
|---|---|---|---|
| 1 | 5.0 | 1 | 0 |
| 2 | 5.0 | 4 | 0 |
| 3 | 7.0 | 1 | 2 |
| 4 | 7.0 | 4 | 0 |
| 5 | 10.0 | 1 | 3 |
| 6 | 10.0 | 4 | 0 |

### Comparative Examples 1 to 3

Polishing was performed under the conditions shown in Table 2 in the same way as in Working Examples 1 to 6 except that the lower polishing plate remained stationary. The results of examination are shown in Table 2.

**Table 2**

| Comparative Example No. | Descending speed of upper polishing plate (mm/second) | Rotating speed of lower polishing plate (rpm) | Percent defective after polishing (%) |
|---|---|---|---|
| 1 | 5.0 | 0 | 22 |
| 2 | 7.0 | 0 | 25 |
| 3 | 10.0 | 0 | 37 |

### Comparative Examples 4 and 5

Polishing was performed under the conditions shown in Table 3 in the same way as in Working Examples 1 to 6 except that the impact-absorbing liquid was not applied to the surface of the substrate stocks. The results of examination are shown in Table 3.

**Table 3**

| Comparative Example No. | Descending speed of upper polishing plate (mm/second) | Rotating speed of lower polishing plate (rpm) | Percent defective after polishing (%) |
|---|---|---|---|
| 4 | 7.0 | 1 | 35 |
| 5 | 7.0 | 4 | 15 |

### Working Examples 7 to 9

Polishing was performed as follows on the substrate stocks of synthetic quartz glass (6-inch (152.4 mm) square and 6.35 mm in thickness) which are held in the work hole shown in FIG. 1. The upper polishing plate was brought into contact with the substrate stocks, while the lower polishing plate was rotating, under the conditions shown in Table 4. The substrate stocks had their surface coated with an impact-absorbing liquid, which is an aqueous solution containing propylene glycol and diethanolamine in a ratio of 10:1 (by weight) such that it has a viscosity of 40 mPa·s at 20°C. The upper polishing plate in contact with the surface of the substrate stocks was rotated, with the interface between the substrate surface and the upper polishing plate being supplied with a slurry composed of pure water and alumina abrasive grains called "FO #2000," made by Fujimi Incorporated Co., Ltd. The substrate stocks underwent polishing in the same way as in Working Examples 1 to 6. The finished specimens were examined for flaws. The results of examination are shown in Table 4.

**Table 4**

| Working Example No. | Descending speed of upper polishing plate (mm/second) | Rotating speed of lower polishing plate (rpm) | Percent defective after polishing (%) |
|---|---|---|---|
| 7 | 5.0 | 1 | 0 |
| 8 | 5.0 | 4 | 0 |
| 9 | 10.0 | 4 | 0 |

### Working Examples 10 and 11

Polishing was performed as follows on the substrate stocks of soda-lime glass (7-inch (178 mm) square and 3.0 mm in thickness) which are held in the work hole shown in FIG. 1. The upper polishing plate was brought into contact with the substrate stocks, while the lower polishing plate was rotating, under the conditions shown in Table 5. The substrate stocks had their surface coated with an impact-absorbing liquid, which is an aqueous solution containing ethylene glycol and triethanolamine in a ratio of 20:1 (by weight) such that it has a viscosity of 37 mPa·s at 20°C. The upper polishing plate in contact with the surface of the substrate stocks was rotated, with the interface between the substrate surface and the upper polishing plate being supplied with a slurry composed of pure water and zirconium oxide abrasive grains called "MZ-1000B," made by Daiichi Kigenso Kagaku Kogyo Co., Ltd. The substrate stocks underwent polishing in the same way as in Working Examples 1 to 6. The finished specimens were examined for flaws. The results of examination are shown in Table 5.

**Table 5**

| Working Example No. | Descending speed of upper polishing plate (mm/second) | Rotating speed of lower polishing plate (rpm) | Percent defective after polishing (%) |
|---|---|---|---|
| 10 | 7.0 | 1 | 0 |
| 11 | 7.0 | 4 | 0 |

Although some preferred embodiments have been described, many modifications and variations may be made thereto in light of the above teachings. It is therefore to be understood that the invention may be practiced otherwise than as specifically described without departing from the scope of protection as defined by the appended claims.

In respect of numerical ranges disclosed in the present description it will of course be understood that in the normal way the technical criterion for the upper limit is different from the technical criterion for the lower limit, i.e. the upper and lower limits are intrinsically distinct proposals.

For the avoidance of doubt it is confirmed that in the general description above, in the usual way the proposal of general preferences and options in respect of different features of the method constitutes the proposal of general combinations of those general preferences and options for the different features, insofar as they are combinable and compatible and are put forward in the same context.

## Claims

1. A method for producing polished substrates, comprising the steps of:
placing substrate stocks (6) on a lower polishing plate (3) in individual work holes (7) formed in a carrier (5),
bringing an upper polishing plate (2) into contact with the surfaces of said substrate stocks, and
rotating said upper and lower polishing plates (2,3), with supply of a polishing slurry to the surfaces of said substrate stocks to polish the substrate stocks;
**characterized in that**
an impact-absorbing liquid is applied onto the surfaces of said substrate stocks, and said bringing of the upper polishing plate (2) into contact with said surfaces is while they are coated with the impact-absorbing liquid and while the lower polishing plate (3) is being rotated.

2. A method of claim 1, wherein when said upper polishing plate (2) is brought into contact with the surface of said substrate stocks (6), said lower polishing plate is rotating at from 1 rpm to 4 rpm.

3. A method of claim 1 or 2 in which when said upper polishing plate (2) is brought into contact with the surface of said substrate stocks (6), the upper and lower polishing plates turn in opposite directions.

4. A method of claim 1, 2 or 3 wherein said impact-absorbing liquid is an aqueous solution containing at least one species selected from glycols, polyacrylic acid and derivatives thereof, poly(meth)acrylic acid and derivatives thereof, diethanolamine and triethanolamine.

5. A method of any one of claims 1 to 4, wherein said impact-absorbing liquid has a viscosity of 10 mPa·s to 100 mPa·s at 20°C.

6. A method of any one of claims 1 to 5, wherein said upper polishing plate (2) is lowered into contact with the surfaces of the substrate stocks at a rate of not more than 20 mm/second.

7. A method of claim 6 wherein said upper polishing plate (2) is lowered into contact with the surfaces of the substrate stocks at a rate of at least 5 mm/second.

8. A method of any one of claims 1 to 7 wherein said impact-absorbing liquid is applied by placing the substrate stocks in a vessel holding the impact-absorbing liquid or by spraying the substrate stocks, held in a working carrier, with the impact-absorbing liquid.

9. A method of any one of claims 1 to 7 wherein said polishing slurry is an aqueous dispersion containing at least one species of abrasive grains selected from alumina abrasive grains, silicon carbide abrasive grains and zirconium oxide abrasive grains.

10. A method of any one of claims 1 to 9, wherein said substrate stocks have a thickness of 0.1 mm to 7 mm before the polishing.

11. A method of claim 10 wherein said substrate stocks have a thickness of 0.1 mm to 1 mm before the polishing.

12. A method of any one of claims 1 to 11 for production of substrates from synthetic quartz glass, soda lime glass, silicon wafer, sapphire, gallium nitride or lithium tantalite.

13. A method of any one of the claims 1 to 11 wherein said substrate stocks are of synthetic quartz glass.

14. A method of any one of the preceding claims wherein said polishing corresponds to a lapping step.

15. A method of any one of the preceding claims wherein said polishing is in double-sided polishing apparatus (1) including said upper polishing plate (2) which is capable of vertical movement, said lower polishing plate (3) facing the upper polishing plate (2), and a plurality of said carriers (5) arranged at equal intervals around a rotating shaft (4) of the lower polishing plate (3), each carrier (5) having a plurality of said work holes (7) each holding a substrate stock (6), and the carrier being thinner than the substrate stocks.

## Patentansprüche

1. Verfahren zur Herstellung von polierten Substraten, das die folgenden Schritte umfasst:
das Platzieren von Substratmaterialien (6) auf einer unteren Polierplatte (3) in einzelnen Arbeitslöchern (7), die in einem Träger (5) ausgebildet sind,
das Inkontaktbringen einer oberen Polierplatte (2) mit den Oberflächen der Substratmaterialien und
das Drehen der oberen und unteren Polierplatte (2, 3), wobei eine Polieraufschlämmung auf die Oberflächen der Substratmaterialien abgegeben wird, um die Substratmaterialien zu polieren;
**dadurch gekennzeichnet, dass**
eine stoßabsorbierende Flüssigkeit auf die Oberflächen der Substratmaterialien aufgetragen wird und das Inkontaktbringen der oberen Polierplatte (2) mit den Oberflächen erfolgt, während sie mit der stoßabsorbierenden Flüssigkeit beschichtet werden und die untere Polierplatte (3) gedreht wird.

2. Verfahren nach Anspruch 1, wobei die untere Polierplatte, wenn die obere Polierplatte (2) in Kontakt mit der Oberfläche der Substratmaterialien (6) gebracht wird, mit 1 U/min bis 4 U/min gedreht wird.

3. Verfahren nach Anspruch 1 oder 2, wobei sich die obere und die untere Polierplatte in entgegengesetzte Richtungen drehen, wenn die obere Polierplatte (2) in Kontakt mit der Oberfläche der Substratmaterialien (6) gebracht wird.

4. Verfahren nach Anspruch 1, 2 oder 3, wobei die stoßabsorbierende Flüssigkeit eine wässrige Lösung ist, die zumindest eine aus Glykolen, Polyacrylsäure und Derivaten davon, Poly(meth)acrylsäure und Derivaten davon, Diethanolamin und Triethanolamin ausgewählte Art enthält.

5. Verfahren nach einem der Ansprüche 1 bis 4, wobei die stoßabsorbierende Flüssigkeit eine Viskosität von 10 mPa·s bis 100 mPa·s bei 20 °C aufweist.

6. Verfahren nach einem der Ansprüche 1 bis 5, wobei die obere Polierplatte (2) zum Kontakt mit den Oberflächen der Substratmaterialien in einer Geschwindigkeit von höchstens 20 mm/s gesenkt wird.

7. Verfahren nach Anspruch 6, wobei die obere Polierplatte (2) zum Kontakt mit den Oberflächen der Substratmaterialien in einer Geschwindigkeit von zumindest 5 mm/s gesenkt wird.

8. Verfahren nach einem der Ansprüche 1 bis 7, wobei die stoßabsorbierende Flüssigkeit aufgetragen wird, indem die Substratmaterialien in ein Gefäß platziert werden, das die stoßabsorbierende Flüssigkeit enthält, oder indem die in einem Arbeitsträger gehaltenen Substratmaterialien mit der stoßabsorbierenden Flüssigkeit besprüht werden.

9. Verfahren nach einem der Ansprüche 1 bis 7, wobei die Polieraufschlämmung eine wässrige Dispersion ist, die zumindest eine Art von Schleifkörnern enthält, die aus Aluminiumoxid-Schleifkörnern, Siliciumcarbid-Schleifkörnern und Zirconiumoxid-Schleifkörnern ausgewählt ist.

10. Verfahren nach einem der Ansprüche 1 bis 9, wobei die Substratmaterialien vor dem Polieren eine Dicke von 0,1 mm bis 7 mm aufweisen.

11. Verfahren nach Anspruch 10, wobei die Substratmaterialien vor dem Polieren eine Dicke von 0,1 mm bis 1 mm aufweisen.

12. Verfahren nach einem der Ansprüche 1 bis 11 zur Herstellung von Substraten aus synthetischem Quarzglas, Kalk-Natron-Glas, Silicium-Wafer, Saphir, Galliumnitrid oder Lithiumtantalit.

13. Verfahren nach einem der Ansprüche 1 bis 11, wobei die Substratmaterialien aus synthetischem Quarzglas bestehen.

14. Verfahren nach einem der vorangegangenen Ansprüche, wobei das Polieren einem Läppschritt entspricht.

15. Verfahren nach einem der vorangegangenen Ansprüche, wobei das Polieren in einer doppelseitigen Poliervorrichtung (1) erfolgt, die die obere Polierplatte (2), die zu einer vertikalen Bewegung in der Lage ist, die untere Polierplatte (3), die der oberen Polierplatte (2) zugewandt ist, und eine Vielzahl der Träger (5) umfasst, die in gleichen Abständen um eine Drehwelle (4) der unteren Polierplatte (3) angeordnet sind, wobei jeder Träger (5) eine Vielzahl der Arbeitslöcher (7) aufweist, die jeweils ein Substratmaterial (6) halten, und der Träger dünner als die Substratmaterialien ist.

## Revendications

1. Procédé de production de substrats polis, comprenant les étapes de :
placer des matériaux de substrat (6) sur une plaque de polissage inférieure (3) dans des trous d'usinage individuels (7) formés dans un support (5),
amener une plaque de polissage supérieure (2) en contact avec les surfaces desdits matériaux de substrat, et
faire tourner lesdites plaques de polissage supérieure et inférieure (2, 3), avec fourniture d'une suspension de polissage aux surfaces desdits matériaux de substrat pour polir les matériaux de substrat ; **caractérisé en ce que**
un liquide d'absorption de choc est appliqué sur les surfaces desdits matériaux de substrat, et ladite mise en contact de la plaque de polissage supérieure (2) avec lesdites surfaces se fait lorsqu'elles sont revêtues du liquide d'absorption de choc et pendant que la plaque de polissage inférieure (3) est en rotation.

2. Procédé selon la revendication 1, dans lequel lorsque ladite plaque de polissage supérieure (2) est mise en contact avec la surface desdits matériaux de substrat (6), ladite plaque de polissage inférieure tourne à une vitesse de 1 tr/min à 4 tr/min.

3. Procédé selon la revendication 1 ou 2, dans lequel lorsque ladite plaque de polissage supérieure (2) est mise en contact avec la surface desdits matériaux de substrat (6), les plaques de polissage supérieure et inférieure tournent dans des directions opposées.

4. Procédé selon la revendication 1, 2 ou 3, dans lequel ledit liquide d'absorption de choc est une solution aqueuse contenant au moins une espèce choisie parmi des glycols, l'acide polyacrylique et des dérivés de celui-ci, l'acide poly(méth)acrylique et des dérivés de celui-ci, la diéthanolamine et la triéthanolamine.

5. Procédé selon l'une quelconque des revendications 1 à 4, dans lequel ledit liquide d'absorption de choc a une viscosité de 10 mPa·s à 100 mPa·s à 20°C.

6. Procédé selon l'une quelconque des revendications 1 à 5, dans lequel ladite plaque de polissage supérieure (2) est abaissée en contact avec les surfaces des matériaux de substrat à une vitesse ne dépassant pas 20 mm/seconde.

7. Procédé selon la revendication 6, dans lequel ladite plaque de polissage supérieure (2) est abaissée en contact avec les surfaces des matériaux de substrat à une vitesse d'au moins 5 mm/seconde.

8. Procédé selon l'une quelconque des revendications 1 à 7, dans lequel ledit liquide d'absorption de choc est appliqué en plaçant les matériaux de substrat dans un récipient contenant le liquide d'absorption de choc ou en pulvérisant les matériaux de substrats, maintenus dans un support d'usinage, avec le liquide d'absorption de choc.

9. Procédé selon l'une quelconque des revendications 1 à 7, dans lequel ladite suspension de polissage est une dispersion aqueuse contenant au moins une espèce de grains abrasifs choisis parmi les grains abrasifs d'alumine, les grains abrasifs de carbure de silicium et les grains abrasifs d'oxyde de zirconium.

10. Procédé selon l'une quelconque des revendications 1 à 9, dans lequel lesdits matériaux de substrat ont une épaisseur de 0,1 mm à 7 mm avant le polissage.

11. Procédé selon la revendication 10, dans lequel lesdits matériaux de substrat ont une épaisseur de 0,1 mm à 1 mm avant le polissage.

12. Procédé selon l'une quelconque des revendications 1 à 11 pour la production de substrats à partir de verre de quartz synthétique, de verre sodocalcique, de plaquette de silicium, de saphir, de nitrure de gallium ou de tantalite de lithium.

13. Procédé selon l'une quelconque des revendications 1 à 11, dans lequel lesdits matériaux de substrat sont en verre de quartz synthétique.

14. Procédé selon l'une quelconque des revendications précédentes, dans lequel ledit polissage correspond à une étape de rodage.

15. Procédé selon l'une quelconque des revendications précédentes, dans lequel ledit polissage survient dans un appareil de polissage double face (1) comprenant ladite plaque de polissage supérieure (2) qui est capable d'un mouvement vertical, ladite plaque de polissage inférieure (3) faisant face à la plaque de polissage supérieure (2), et une pluralité desdits supports (5) agencés à des intervalles égaux autour d'un arbre rotatif (4) de la plaque de polissage inférieure (3), chaque support (5) ayant une pluralité desdits trous d'usinage (7) contenant chacun un matériau de substrat (6), et le support étant plus mince que les matériaux de substrat.
